(19) Europäisches Patentamt
European Patent Office
Office européen des brevets

(11) **EP 2 857 901 B1**

(12) **EUROPÄISCHE PATENTSCHRIFT**

(45) Veröffentlichungstag und Bekanntmachung des Hinweises auf die Patenterteilung:
**20.04.2016 Patentblatt 2016/16**

(51) Int Cl.:
*G03F 7/20* (2006.01)          *G01D 5/347* (2006.01)
*G01B 11/14* (2006.01)

(21) Anmeldenummer: **14179262.2**

(22) Anmeldetag: **31.07.2014**

(54) **Anordnung zur Positionierung eines Werkzeugs relativ zu einem Werkstück**

Assembly for positioning a tool relative to a workpiece

Système de positionnement d'un outil par rapport à une pièce à usiner

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.10.2013 DE 102013220214**

(43) Veröffentlichungstag der Anmeldung:
**08.04.2015 Patentblatt 2015/15**

(73) Patentinhaber: **Dr. Johannes Heidenhain GmbH 83301 Traunreut (DE)**

(72) Erfinder:
• **Holzapfel, Wolfgang 83119 Obing (DE)**
• **Drescher, Jörg 83122 Samerberg (DE)**
• **Dodds-Eden, Katie 83278 Traunstein (DE)**
• **Musch, Bernhard 83301 Traunreut (DE)**

(56) Entgegenhaltungen:
EP-A2- 1 762 828          EP-A2- 1 826 615
US-A1- 2011 141 451      US-B2- 7 483 120

• GAO W ET AL: "A Three-axis Displacement Sensor with Nanometric Resolution", CIRP ANNALS, ELSEVIER BV, NL, CH, FR, Bd. 56, Nr. 1, 1. Januar 2007 (2007-01-01) , Seiten 529-532, XP027151117, ISSN: 0007-8506 [gefunden am 2007-01-01]

EP 2 857 901 B1

**Beschreibung**

GEBIET DER TECHNIK

Die vorliegende Erfindung betrifft eine Anordnung zur Positionierung eines Werkzeugs relativ zu einem Werkstück gemäß dem Oberbegriff von Anspruch 1, mit der eine hochgenaue Bestimmung der Relativposition der zwei zueinander beweglichen Objekte und damit eine sehr genaue Positionierung möglich ist.

STAND DER TECHNIK

Vor allem im Bereich der Herstellung von Integrierten Schaltungen mit Strukturgrößen weit unterhalb eines Mikrometers ist es notwendig, die Halbleitersubstrate (auch Wafer oder im Sinne dieser Anmeldung Werkstück genannt) sehr genau unter einem Werkzeug wie beispielsweise der Linse eines Belichtungsapparates zu positionieren, mit dessen Hilfe dann feinste Strukturen in einen zuvor auf dem Wafer aufgebrachten lichtempfindlichen Lack übertragen werden.

Hierzu ist es beispielsweise aus der US 7483120 B2 bekannt, den Wafer auf einem beweglichen Tisch abzulegen, der relativ zur Linse des Belichtungsapparates positionierbar ist. Rund um die Linse sind in einer X-Y-Ebene vier Gitterplatten als Maßverkörperungen angeordnet und möglichst starr mit der Linse verbunden. Die optische Achse der Linse steht senkrecht auf der Ebene der Gitterplatten und definiert eine Z-Richtung. Tisch und Wafer liegen parallel zu den Gitterplatten bzw. Maßverkörperungen. In den Ecken des Tisches sind Abtastköpfe von Positionsmessgeräten angeordnet, die mittels Licht die Gitterplatten abtasten. Bewegt sich der Tisch relativ zu den Gitterplatten, bilden die Abtastköpfe periodische Signale, aus denen durch Abzählen der Perioden und feine Unterteilung einzelner Perioden (Interpolation) hochgenaue Werte für die Änderung der Position gewonnen werden. Ermittelt man einmal eine absolute Position z.B. durch Erfassung von Referenzmarken, ist die Bestimmung der Positionsänderung gleichbedeutend mit der Bestimmung einer absoluten Position, da man die absolute Position ausgehend von der Referenzposition aus der Positionsänderung berechnen kann.

Mit dem Begriff "Ecken eines Tisches" sind hier voneinander verschiedene und für eine gegebene Tischgröße möglichst weit voneinander beabstandete Randbereiche des Tisches gemeint. Die Anordnung von Abtastköpfen in solchen "Ecken" ist aus verschiedenen Gründen zweckmäßig. Abtastköpfe können nur außerhalb des vom (mittig auf dem Tisch angeordneten) Werkstück eingenommenen Bereiches angeordnet sein. Ein möglichst großer Abstand von Abtastköpfen untereinander ermöglicht außerdem eine genauere Berechnung von Rotationen aus den in den Ecken gemessenen linearen Verschiebungen. Außerdem können einzelne Ecken oder Randbereiche des Tisches in den Bereich des Werkzeugs gelangen, so dass ein dort angeordneter Abtastkopf keine Gitterplatte mehr abtasten kann. Für eine stets hochgenaue Positionsbestimmung ist es sinnvoll dafür zu sorgen, dass zu jeder Zeit Abtastköpfe aus möglichst weit voneinander entfernten Bereichen des Tisches abtasten können. Hierfür kann es vorteilhaft sein, die Abtastköpfe in mehreren Eckbereichen zusammenzufassen, von denen nie mehr als einer in den Bereich des Werkzeugs gelangen kann.

In einer solchen Ecke nahe beieinander liegende Abtastköpfe für verschiedene Messrichtungen reduzieren die für die Gitterplatten benötigte Größe. Idealerweise können die Messungen auch in einem einzigen Abtastkopf integriert werden, wofür weiter unten Beispiele beschrieben werden.

Im Sinne dieser Anmeldung liegen zwei Abtastköpfe für verschiedene Messrichtungen dann "in der selben Ecke des Tisches", wenn ihr Abstand klein ist im Vergleich zur Ausdehnung des Tisches. Haben zwei Abtastköpfe einen Abstand, der vergleichbar ist mit den Abmessungen des Tisches, so liegen sie in verschiedenen Ecken bzw. Randbereichen. Zwei Abtastköpfe liegen jedenfalls dann in verschiedenen Ecken des Tisches, wenn ihr Abstand größer als ein Zehntel der Ausdehnung des Tisches ist. Für runde Tische kann als Ausdehnung deren Durchmesser gelten, für rechteckige oder quadratische Tische deren Diagonale.

Für die Positionierung des Tisches in der X-Y-Ebene müssen dessen Freiheitsgrade in dieser Ebene erfasst werden. Dies sind die linearen Verschiebungen in der X- bzw. Y-Richtung, sowie die Rotation rZ um die Z-Achse, zusammen auch als In-Plane Freiheitsgrade bezeichnet, weil alle drei Freiheitsgrade in der X-Y-Ebene liegen. Zur Erfassung dieser drei Freiheitsgrade X, Y, rZ genügt es, z. B. in zwei Ecken des Tisches die Verschiebung in X zu messen, und in einer weiteren Ecke die Verschiebung in Y. Die Rotation rZ lässt sich dann leicht ausrechnen. Da aber bei der Verschiebung des Tisches im Zuge der Belichtung des Wafers eine einzelne Ecke in Bereiche nahe der Linse geraten kann, in denen keine Gitterplatte mehr abgetastet werden kann, sollte jede der Ecken des Tisches einen Abtastkopf aufweisen. In der US 7483120 B2 ist auch offenbart, dass es vorteilhaft ist, in wenigstens einer der Ecken nicht nur die Verschiebung in X-Richtung, sondern auch die Verschiebung in Y-Richtung zu messen. Redundante Messungen können zu einer Steigerung der Messgenauigkeit durch Mitteln herangezogen werden, oder auch um z.B. thermische Ausdehnungen oder Vibrationen des Tisches zu berücksichtigen.

Weiter erwähnt die US 7483120 B2, dass in den Ecken jeweils auch eine Messung des Abstandes zu den Gitterplatten erfolgen kann, also eine Positionsmessung der Tischecken in Z-Richtung. Mit diesen Messungen können auch die übrigen drei Freiheitsgrade des Tisches erfasst werden, also die lineare Verschiebung in Z-Richtung und die Rotationen rX und rY um die X- bzw. Y-Achse. So kann man zudem erreichen, dass zu jeder Zeit Messungen in allen drei Raumrichtungen in einem Eckbereich möglichst nahe am Wirkungsort des Werkzeuges (dem Tool Center Point) zur Verfügung stehen. Durch eine derartige 3D-Positionserfassung in einer Ecke erhöht sich die Genauigkeit der Positionierung des Bearbeitungswerkzeugs gegenüber dem Werkstück.

Eine für solche Anwendungen geeignete optische Positionsmesseinrichtung ist aus der EP 1762828 A2 der Anmelderin bekannt. Diese umfasst eine Maßverkörperung (hier eine der Gitterplatten), sowie einen Abtastkopf zur Abtastung der Maßverkörperung, der in der Ecke des Tisches angeordnet ist.

Der Abtastkopf ist hierbei derart ausgebildet, dass darüber eine gleichzeitige Positionsbestimmung entlang einer lateralen Verschiebungsrichtung (also z.B. X) als auch entlang einer vertikalen Verschiebungsrichtung (Z) des Tisches möglich ist. Der Abtastkopf weist damit zwei Messachsen auf. Zur Positionsbestimmung in der lateralen und vertikalen Verschiebungsrichtung ist ein erster und ein zweiter Abtaststrahlengang ausgebildet (Ein Abtaststrahlengang für jede Messachse), in denen jeweils aus zwei nichtspiegelsymmetrischen, interferierenden Teilstrahlenbündeln ausgangsseitig eine Gruppe phasenverschobener Signale erzeugbar ist, die miteinander interferieren und in einem Fotodetektor periodische Signale erzeugen.

In hochgenauen Positionsmesseinrichtungen der hier betrachteten Art ist es notwendig, die im Abtastkopf generierten periodischen Signale einer Kompensation hinsichtlich ihrer Amplitude, ihres Offsets und ihrer Phasenlage zu unterziehen, da nur dann eine sehr feine Bestimmung der Position innerhalb einer Signalperiode möglich ist. Da diese Kompensation während des Messbetriebes kontinuierlich abläuft, wird sie auch als Online-Kompensation bezeichnet.

In der Positionsmesseinrichtung der EP 1762828 A2 wird daher darauf geachtet, dass auch bei einer reinen Verschiebung in der lateralen Verschiebungsrichtung periodische Signale in allen Fotodetektoren entstehen, obwohl in der vertikalen Verschiebungsrichtung keine Bewegung vorliegt.

Dies wird gemäß der EP 1762828 A2 erreicht, indem die beiden Empfindlichkeitsvektoren der Messachsen des Abtastkopfes nicht genau in die laterale bzw. vertikale Richtung zeigen, sondern unter bestimmten Winkeln zu diesen Richtungen angeordnet sind. Der Empfindlichkeitsvektor einer Messachse gibt dabei die Bewegungsrichtung an, in der sich das Positionssignal der jeweiligen Messachse pro zurückgelegter Längeneinheit am schnellsten erhöht. Er beschreibt somit eine Eigenschaft der Messachse. Durch eine Verrechnung der beiden gewonnenen periodischen Signale kann die tatsächliche Bewegung in den gewünschten Messrichtungen (lateral und vertikal) erhalten werden.

## ZUSAMMENFASSUNG DER ERFINDUNG

Der vorliegenden Erfindung liegt die Aufgabe zugrunde, eine Anordnung zur Positionierung eines Werkzeugs relativ zu einem Werkstück zu schaffen, mit der die Relativposition noch genauer erfasst und damit eingestellt werden kann.

Diese Aufgabe wird erfindungsgemäß durch eine Anordnung mit den Merkmalen des Anspruchs 1 gelöst.

Vorteilhafte Ausführungen der erfindungsgemäßen optischen Positionsmesseinrichtung ergeben sich aus den Maßnahmen, die in den abhängigen Ansprüchen aufgeführt sind.

Es wird eine Anordnung zur Positionierung eines Werkzeugs relativ zu einem Werkstück beschrieben, mit einem beweglichen Tisch zur Aufnahme eines Werkstücks, wobei der Tisch während der Bearbeitung des Werkstücks Bewegungen in zwei Hauptbewegungsrichtungen ausführt, sowie mit einer oder mehreren flächigen Maßverkörperungen, die ortsfest um das Werkzeug herum angeordnet und in der Ebene der Hauptbewegungsrichtungen ausgedehnt sind, sowie mit Abtastköpfen zur Erfassung der Lage des Tisches relativ zu den Maßverkörperungen, die in mindestens drei Ecken des Tisches angebracht sind, wobei die Lage des Tisches mit den Abtastköpfen in sechs Freiheitsgraden bestimmbar ist. In mindestens einer der Ecken sind ein oder mehrere Abtastköpfe mit insgesamt wenigstens drei Messachsen zur 3D-Positionserfassung in drei unabhängigen Raumrichtungen vorhanden. Die Empfindlichkeitsvektoren dieser wenigstens drei Messachsen zur 3D-Positionserfassung liegen dabei weder parallel zur X-Z-Ebene noch parallel zur Y-Z-Ebene.

Auf diese Weise liefern alle Messachsen periodische Signale, wenn der Tisch in einer Hauptbewegungsrichtung (X, Y) bewegt wird. Die Signale sind daher bei jeder Bewegung des Tisches in die X- oder Y-Richtung kompensierbar.

Mit der angegebenen Erfindung ist in einer Ecke des Tisches die Erfassung von Positionsmesswerten in drei unabhängigen Raumrichtungen möglich. Die Genauigkeit der Messung wird während der Maschinenaktion nicht durch den Ausfall der Online-Kompensation in einer der Messachsen beeinträchtigt.

## KURZE BESCHREIBUNG DER ZEICHNUNGEN

Es zeigt

Figur 1      die Ausrichtung eines Empfindlichkeitsvektors in einem polaren Koordinatensystem,

Figur 2      einen Abtastkopf für zwei Messrichtungen gemäß dem Stand der Technik,

Figur 3      einen Abtastkopf für drei Messrichtungen als erstes Ausführungsbeispiel,

Figur 4      zwei in einer Ecke angeordnete Abtastköpfe für insgesamt vier Messrichtungen als zweites Ausführungsbeispiel,

Figur 5 einen Abtastkopf, der die vier Messrichtungen des zweiten Ausführungsbeispiel abdeckt, als drittes Ausführungsbeispiel,

Figur 6 eine Seitenansicht der Anordnung zur Positionierung eines Werkzeugs relativ zu einem Werkstück.

## BESCHREIBUNG DER AUSFÜHRUNGSFORMEN

Bevor im Anschluss konkrete Ausführungsbeispiele der erfindungsgemäßen optischen Positionsmesseinrichtung erläutert werden, sei vorab kurz das Konzept der Positionsmesseinrichtung erläutert, die aus der EP 1 762 828 A2 bekannt ist. Diese ist wie eingangs erwähnt zur Erfassung von Positionsänderungen entlang zweier Verschiebungsrichtungen geeignet. Im entsprechenden Abtastkopf sind zwei Abtaststrahlengänge zueinander verkippt bzw. asymmetrisch ausgebildet. Hierbei wird das von einer Lichtquelle gelieferte Strahlenbündel über einen ersten Lichtleiter, ausgebildet als Singlemode-Faser, dem Abtastsystem zugeführt und nach der Auskopplung aus dem Lichtleiter über eine Kollimationsoptik kollimiert. Danach gelang das kollimierte Strahlenbündel auf ein Aufspaltgitter, in dem es in zwei Abtaststrahlengänge für zwei Messachsen aufgespalten wird. Die beiden Messachsen seien nachfolgend auch als A-Achse und B-Achse der Positionsmesseinrichtung bezeichnet. Die eigentlich interessierenden Positionsinformationen entlang der lateralen Verschiebungsrichtung X und der vertikalen Verschiebungsrichtung Z ergeben sich aus der Summation und der Differenzbildung der Positionssignale A, B gemäß den nachfolgenden Gleichungen 1 a und 1 b:

$$X = (A+B)/2 \qquad (Gl.\ 1a)$$

$$Z = (A-B)/2*SPz/SPx \qquad (Gl.\ 1b)$$

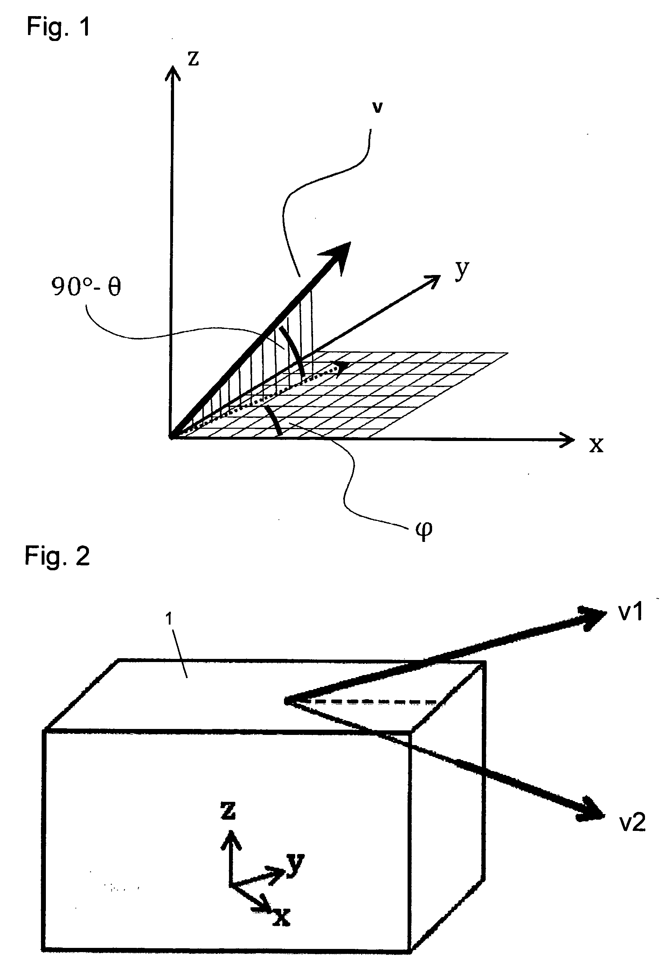

Hierbei bezeichnet SPz die Signalperiode in Z-Richtung und SPx die Signalperiode in X-Richtung.
In diesen Gleichungen spiegelt sich wieder, dass bei einer reinen Bewegung in X-Richtung sowohl die A-Achse als auch die B-Achse der Positionsmesseinrichtung periodische Signale liefert, aus deren Summe die tatsächliche Verschiebung in X, und aus deren Differenz die tatsächliche Verschiebung in Z gewonnen werden kann.
Die Strahlenbündel gelangen in den jeweiligen Abtaststrahlengängen zunächst auf die Maßverkörperung (Gitterplatte), die als Reflexionsgitter ausgebildet ist, werden darüber in Teilstrahlenbündel +/-1. Beugungsordnung aufgespalten und zurück zum Abtastsystem gebeugt. Dort wird jedes der Teilstrahlbündel durch ein diffraktives Dachkantprisma in Richtung Maßverkörperung zurück gelenkt. An der Maßverkörperung interferieren die beiden Teilstrahlenbündel jeweils, die überlagerten Teilstrahlenbündel werden anschließend zu einer Auskoppeloptik weitergeleitet, die aus einer Fokussier- und einer Feldlinse besteht und daraufhin in einen zweiten Lichtleiter ausgekoppelt, der sechs Multimode-Lichtleitfasern umfasst.
Zum besseren Verständnis der Erfindung sei an dieser Stelle das Konzept des Empfindlichkeitsvektors näher erläutert.
Jeder Messachse kann man einen normierten Empfindlichkeitsvektor v zuordnen. Der Empfindlichkeitsvektor spezifiziert die Bewegungsrichtung, in der sich das Positionssignal der Messachse pro zurückgelegter Längeneinheit am schnellsten erhöht. Ändert sich die Position der Messachse gegenüber der Maßverkörperung um einen Verschiebungsvektor $\Delta\vec{S}$, dann ist die Änderung des Positionssignals der Messachse (in linearer Näherung) durch das Skalarprodukt $v \cdot \Delta\vec{S}$ gegeben. Den Empfindlichkeitsvektor v einer Messachse kann man wie folgt auch mit zwei Winkeln $\theta$, $\varphi$ charakterisieren, siehe auch Figur 1:

$$v = \begin{pmatrix} \sin(\theta)\cos(\varphi) \\ \sin(\theta)\sin(\varphi) \\ \cos(\theta) \end{pmatrix}$$

Der Polarwinkel $\theta$ ist der Winkel zur Z-Achse und liegt per Konvention zwischen 0° und 180°. Für $\theta$ = 90° liegt der Empfindlichkeitsvektor in der X,Y-Ebene. Der Azimutwinkel $\varphi$ gibt in der senkrechten Projektion von v auf die X,Y-Ebene den Winkel zur X-Achse an.
Die Figur 2 zeigt einen Abtastkopf 1 für zwei Messrichtungen (also mit zwei in den Abtastkopf 1 integrierten Messachsen) gemäß dem oben genannten Stand der Technik. Die Empfindlichkeitsvektoren v1 und v2 entsprechend der beiden Messachsen A und B sind gemäß der Notation aus Figur 1 durch $\theta$ = 90° + $\Delta\theta$, $\varphi$ = 45° und $\theta$ = 90° - $\Delta\theta$, $\varphi$ = 45° gegeben, wobei $\Delta\theta$ ein Winkel ist, der zwischen 0 und 90° liegt. Dadurch, dass die Empfindlichkeitsvektoren v1, v2 nicht genau in der X-Y-Ebene, sondern spielgelsymmetrisch zu dieser X-Y-Ebene liegen, lässt sich durch Subtraktion der Messwerte ein Positionswert in Z-Richtung ermitteln. Durch Addition erhält man hingegen einen Positionswert entlang einer Achse in der X-Y-Ebene.
Für die Positionsbestimmung in einem Eckbereich in allen drei Raumrichtungen (hier auch 3D-Positionserfassung genannt) liegt es nun nahe, drei Messachsen mit Empfindlichkeitsvektoren in X-, Y- und Z-Richtung vorzusehen. Diese Wahl der Empfindlichkeitsvektoren für die 3D-Positionserfassung ist jedoch ungünstig. Typischerweise werden in der Auswerteelektronik einer Messachse einige ungewollte Störungen, wie z.B.

Schwankungen in den Signalamplituden, adaptiv kompensiert. Diese sogenannte Online-Kompensation kann nur korrekt arbeiten, wenn sich die Messachse kontinuierlich in einer Richtung über den Maßstab bewegt und dabei mehrere Signalperioden überstreicht. Soll sich nun die Maschine entlang einer ihrer Hauptbewegungsrichtungen bewegen, z.B. parallel zur X-Achse, dann wären die Positionswerte der Messachsen in Y- und Z-Richtung konstant, es würden keine periodischen Signale gebildet. Da dies zum Ausfall der Online-Kompensation führen würde, erhöhten sich die Messfehler in diesen Richtungen.

Die hier betrachteten Maschinen weisen Hauptbewegungsrichtungen auf, die gemäß der eingangs gewählten Bezeichnungen mit X und Y bezeichnet sind. Während der Belichtung eines Wafers bewegt sich der Tisch vorwiegend nur in X-Richtung. Gelegentlich findet ein "Zeilensprung" mit einer Bewegung in Y-Richtung statt, bevor der Tisch wieder in X-Richtung bewegt wird.

Damit während einer Bewegung in diesen Hauptbewegungsrichtungen X, Y eine Kompensation der Detektorsignale erfolgen kann, darf kein Empfindlichkeitsvektor einer beteiligten Messachse senkrecht auf der Bewegungsrichtung der Maschine stehen. Für eine Maschine, deren Hauptbewegungsrichtungen parallel zur X- und Y-Achse liegen, dürfen die Empfindlichkeitsvektoren folglich nicht senkrecht auf der X- bzw. Y-Achse stehen.

Ganz allgemein folgt daraus, dass die Empfindlichkeitsvektoren der 3D-Positionserfassung (die sich auf eine Ecke des Tisches bezieht) weder in der X-Z-Ebene noch in der Y-Z-Ebene liegen dürfen. Genauer gesagt sollte der Winkel zwischen dem Empfindlichkeitsvektor und der X-Z-Ebene nicht geringer als etwa 1° sein. Genauso sollte der Winkel zwischen dem Empfindlichkeitsvektor und der Y-Z-Ebene mindestens etwa 1° betragen. Damit sind mit Bezugnahme auf Figur 1 unter anderem die Winkelbereiche $-1° < \varphi < 1°$, $89° < \varphi < 91°$, $-89° < \varphi < -91°$, $179° < \varphi < 181°$ sowie $0 \leq \theta < 1°$ und $179° < \theta \leq 180°$ jeweils ausgeschlossen. Insbesondere darf kein Empfindlichkeitsvektor parallel zur Z-Richtung sein.

Um für eine hochgenaue Positionsmessung jederzeit eine Online-Kompensation durchführen zu können, müssen für die 3D-Positionserfassung Messachsen mit mindestens drei unabhängigen Empfindlichkeitsvektoren geeignet ausgerichtet sein. Bei einer Bewegung entlang der Hauptbewegungsrichtungen der Maschine müssen in allen Messachsen periodische Signale entstehen. Die hierzu oben angegeben allgemeinen Vorschriften seien nun anhand konkreter Ausführungsbeispiele näher erläutert.

Um die Verrechnung der Positionssignale einfach zu gestalten ist es vorteilhaft (aber nicht zwingend erforderlich) für die ersten beiden Empfindlichkeitsvektoren auf die Winkel $(\varphi = \varphi_1, \theta = 90° + \Delta\theta)$ und $(\varphi = \varphi_1, \theta = 90° - \Delta\theta)$ zu setzen, wobei $\varphi_1$ und $\Delta\theta$ in den Bereichen $1° < \varphi_1 < 89°$, $1° < \Delta\theta < 89°$ so gewählt werden, dass der Winkel zur X-Z-Ebene und der Winkel zur Y-Z-Ebene mindestens 1° beträgt. Für $\varphi_1$ ist die Wahl $\varphi_1 = 45°$ wiederum besonders einfach, aber nicht zwingend erforderlich. Durch Subtraktion der Messwerte aus den ersten beiden Messachsen erhält man nun bis auf einen Skalierungsfaktor sofort die Z-Position. Durch Addition der Messwerte misst man in der X,Y-Ebene in $\varphi_1$-Richtung. Eine Positionsmesseinrichtung mit zwei derartigen Empfindlichkeitsvektoren ist beispielsweise in EP 1762828 A2 beschrieben.

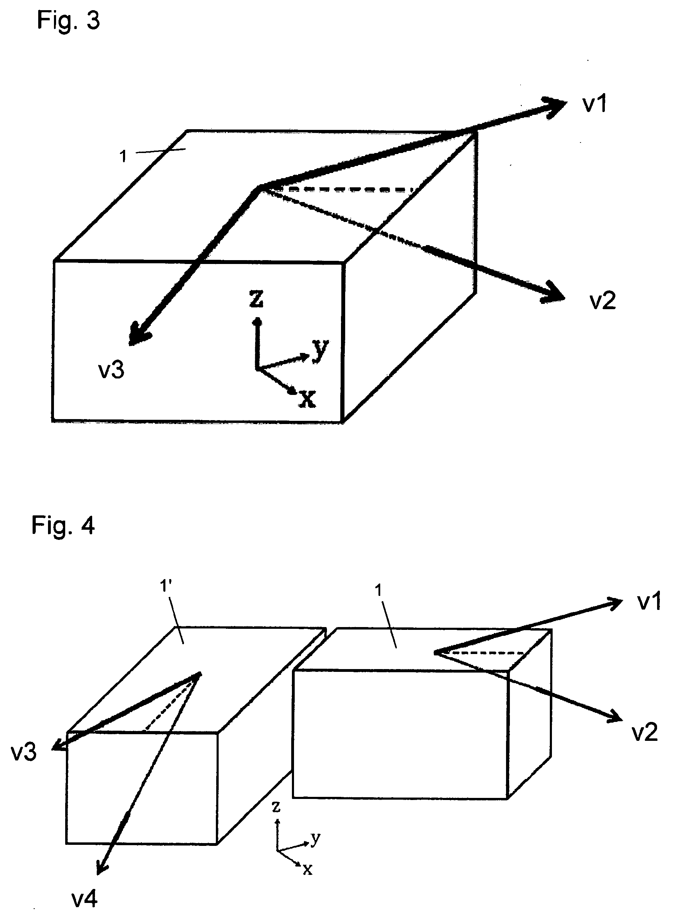

Analog zur Figur 2 zeigt Figur 3 nun einen Abtastkopf 1, der insgesamt drei Bewegungsrichtungen erfassen kann, der also drei Messachsen mit drei Empfindlichkeitsvektoren v1, v2, v3 integriert hat und für jede dieser Richtungen periodische Signale erzeugt, die kompensiert werden müssen. Dieser Abtastkopf 1 ist also zur 3D-Positionserfassung geeignet. Die Hauptbewegungsrichtungen der zu überwachenden Maschine sind X und Y, außerdem soll die Lage in Z-Richtung erfasst werden. Der Abtastkopf 1 ist im Randbereich bzw. in einer Tischecke gemäß oben gegebener Definition angeordnet. Der Abtastkopf 1 weist neben den bereits aus Figur 2 bekannten Messachsen mit Empfindlichkeitsvektoren v1 und v2 eine dritte Messachse mit einem dritten Empfindlichkeitsvektor v3 auf, für den gilt $\theta = 90°$, $\varphi = 90° + \varphi_1$. So ein Abtastkopf 1, der drei Messachsen integriert hat, ist ausführlich in der Patentanmeldung mit der Nummer DE 102013220184.2 der Anmelderin beschrieben.

Eine weitere Möglichkeit, die oben gegebenen Randbedingungen für die Ausrichtung der Empfindlichkeitsvektoren einzuhalten besteht darin, zwei Abtastköpfe 1, 1' gemäß dem Stand der Technik (entsprechend Figur 2) wie in Figur 4 dargestellt in der selben Ecke dicht beieinander und um 90 Grad um die Z-Achse verdreht anzuordnen, und deren insgesamt vier periodischen Signale miteinander zur 3D-Positionserfassung zu verrechnen. Auch hierbei ist darauf zu achten, dass alle Signale während der Bewegung in den Hauptbewegungsrichtungen X und Y kompensierbar sind. Dies wird erreicht, indem die Ausrichtung der beiden zusätzlichen Empfindlichkeitsvektoren v3 und v4 entsprechend $(\varphi = 90° + \varphi_1, \theta = 90° + \Delta\theta)$ und $(\varphi = 90° + \varphi_1, \theta = 90° - \Delta\theta)$ gewählt werden, zusätzlich zur bereits in der Figur 2 beschriebenen Ausrichtung der Empfindlichkeitsvektoren v1 und v2. In diesem Beispiel werden vier Messachsen, von denen je zwei in einem Abtastkopf integriert sind, zur 3D-Postionserfassung herangezogen.

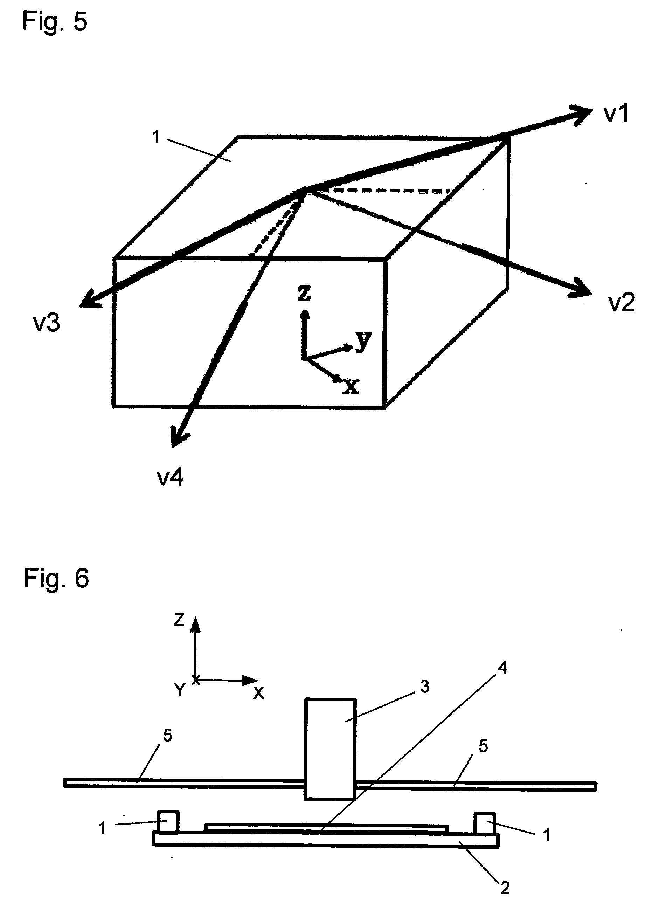

Als letztes Ausführungsbeispiel ist in Figur 5 ein einziger Abtastkopf 1 gezeigt, der die vier schon zur Figur 3 beschriebenen Empfindlichkeitsvektoren v1, v2, v3 und v4 in einem einzigen Abtastkopf mit insgesamt vier Messachsen vereinigt. So ein Abtastkopf 1, der vier Messachsen integriert hat, ist ebenfalls in der Patentanmeldung mit der Nummer DE 102013220184.2 der Anmelderin beschrieben.

Die Empfindlichkeitsvektoren v1, v2, v3, v4 aller Ausführungsbeispiele können natürlich jeweils in einer in der X-Y-Ebene um 90°, 180°, oder 270° gedrehten Variante zum Einsatz kommen. Auch ein gemeinsamer Vorzeichenwechsel aller Empfindlichkeitsvektoren ändert am Funktionsprinzip nichts. Diese Modifikationen sind nur Ausdruck eines gedrehten oder invertierten Koordinatensystems innerhalb einer Ecke und keine echten Abwandlungen in der Wahl der Richtung der Empfindlichkeitsvektoren v1, v2, v3, v4.

Abschließend ist in der Figur 6 ein Tisch 2 dargestellt, in dessen Ecken jeweils ein Abtastkopf 1 gemäß dem ersten oder dritten Ausführungsbeispiel angeordnet ist, so dass hier in jeder Ecke des Tisches eine 3D-Positionserfassung erfolgen kann. Auf dem Tisch 2 liegt ein Werkstück 4 in Form eines Wafers, der mittels des Werkzeugs 3 (einer Linse) belichtet wird. Die Abtastköpfe 1 tasten Maßverkörperungen 5 ab, die starr mit dem Werkzeug 3 verbunden sind. Auf diese Weise wird die Position des Werkstücks 4 relativ vom Werkzeug ermittelt und eingestellt.

Zusammenfassend erlaubt die erfindungsgemäße Anordnung zur Positionierung eines Werkzeugs relativ zu einem Werkstück dank der Ausrichtung der Empfindlichkeitsvektoren eine Positionsmessung in einer Ecke eines relativ zu einem Werkzeug beweglichen Tisches in drei voneinander unabhängigen Richtungen (hier 3D-Positionserfassung genannt), so dass bei einer Bewegung in den Hauptbewegungsrichtungen der jeweiligen Bearbeitungsmaschine jederzeit kompensierbare periodische Signale entstehen. Neben den erwähnten Belichtungsmaschinen können auch andere Anwendungen mit hohen Anforderungen an die Positioniergenauigkeit von der Erfindung profitieren, wie beispielsweise Mikroskope, Elektronenstrahlschreiber oder Laserschreiber.

**Patentansprüche**

1. Anordnung zur Positionierung eines Werkzeugs relativ zu einem Werkstück mit

   - einem beweglichen Tisch (2) zur Aufnahme eines Werkstücks (4), wobei der Tisch (2) während der Bearbeitung des Werkstücks Bewegungen in zwei Hauptbewegungsrichtungen (X, Y) ausführt,
   - einer oder mehreren flächigen Maßverkörperungen (5), die ortsfest um das Werkzeug (3) herum angeordnet sind und in der Ebene der Hauptbewegungsrichtungen (X,Y) ausgedehnt sind,
   - Abtastköpfen (1, 1') zur Erfassung der Lage des Tisches (2) relativ zu den Maßverkörperungen (5), die in mindestens drei Ecken des Tisches (2) angebracht sind, wobei die Lage des Tisches (2) mit den Abtastköpfen (1, 1') in sechs Freiheitsgraden (X, Y, Z, rX, rY, rZ) bestimmbar ist,
   - wobei in mindestens einer der Ecken ein oder mehrere Abtastköpfe (1, 1') mit insgesamt wenigstens drei Messachsen zur 3D-Positionserfassung in drei unabhängigen Raumrichtungen (X, Y, Z) vorhanden sind,

   **dadurch gekennzeichnet, dass**

   - Empfindlichkeitsvektoren (v1, v2, v3, v4) der Messachsen zur 3D-Positionserfassung weder parallel zur X-Z-Ebene noch parallel zur Y-Z-Ebene liegen.

2. Anordnung nach Anspruch 1, **dadurch gekennzeichnet, dass** die Empfindlichkeitsvektoren (v1, v2, v3, v4) der Messachsen zur 3D-Positionserfassung mindestens einen Winkel von 1° mit der X-Z-Ebene beziehungsweise der Y-Z-Ebene einschließen.

3. Anordnung nach Anspruch 1 oder 2, **dadurch gekennzeichnet, dass** ein erster und zweiter Empfindlichkeitsvektor (v1, v2) einer ersten und zweiten Messachse zur 3D-Positionserfassung bezüglich der X-Y-Ebene spiegelsymmetrisch liegen.

4. Anordnung nach Anspruch 3, **dadurch gekennzeichnet, dass** die Projektionen der zur X-Y-Ebene spiegelsymmetrischen ersten und zweiten Empfindlichkeitsvektoren (v1, v2) auf die X-Y-Ebene zwei identische Vektoren liefern, die gegenüber der X-Richtung in der X-Y-Ebene um 45, 135, 225 oder 315 Grad gedreht sind.

5. Anordnung nach Anspruch 3 oder 4, **dadurch gekennzeichnet, dass** ein dritter Empfindlichkeitsvektor (v3) einer dritten Messachse in der X-Y-Ebene liegt und linear unabhängig von den beiden zur X-Y-Ebene spiegelsymmetrischen Empfindlichkeitsvektoren (v1, v2) ist.

6. Anordnung nach Anspruch 5, **dadurch gekennzeichnet, dass** der dritte Empfindlichkeitsvektor (v3) senkrecht auf den zur X-Y-Ebene spiegelsymmetrischen Empfindlichkeitsvektoren (v1, v2) steht.

7. Anordnung nach Anspruch 3 oder 4, **dadurch gekennzeichnet, dass** zur 3D-Psoitonserfassung eine dritte und vierte Messachse mit einem dritten und vierten Empfindlichkeitsvektor (v3, v4) vorhanden ist, der jeweils durch eine Rotation von 90 Grad um die Z-Richtung des ersten bzw. zweiten Empfindlichkeitsvektors (v1, v2) der ersten und zweiten Messachse erhalten wird.

8. Anordnung nach Anspruch 7, **dadurch gekennzeichnet, dass** die erste und zweite Messachse in einem ersten Abtastkopf (1) sowie die dritte und vierte Messachse in einem zweiten Abtastkopf (1') integriert sind.

**9.** Anordnung nach einem der Ansprüche 1-7, **gekennzeichnet dadurch, dass** alle Messachsen zur 3D-Postionserfassung in einen einzigen Abtastkopf (1) integriert sind.

**10.** Anordnung nach einem der vorhergehenden Ansprüche, **dadurch gekennzeichnet, dass** in mindestens drei Ecken des Tisches (2) Messachsen zur 3D-Positionserfassung vorhanden sind.

**Claims**

**1.** Assembly for positioning a tool relative to a workpiece, comprising:

- a movable table (2) for receiving a workpiece (4), the table (2) performing movements in two main directions of movement (X, Y) during the processing of the workpiece,
- one or more planar dimensional scales (5), which are arranged in a stationary manner about the tool (3) and are made to extend in a plane of the main directions of movement (X, Y),
- scanning heads (1, 1') for detecting the position of the table (2) relative to the dimensional scales (5), which are mounted in at least three corners of the table (2), the position of the table (2) being determinable with the scanning heads (1 1') in six degrees of freedom (X, Y, Z, rX, rY, rZ),
- one or more scanning heads (1, 1') with a total of at least three measuring axes being provided in at least one of the corners for 3D position detection in three independent spatial directions (X, Y, Z),

**characterized in that**

- sensitivity vectors (v1, v2, v3, v4) of the measuring axes for the 3D position detection lie neither parallel to the X-Z plane nor parallel to the Y-Z plane.

**2.** Assembly according to Claim 1, **characterized in that** the sensitivity vectors (v1, v2, v3, v4) of the measuring axes for the 3D position detection form an included angle of at least 1° with the X-Z plane or the Y-Z plane.

**3.** Assembly according to Claim 1 or 2, **characterized in that** a first and a second sensitivity vector (v1, v2) of a first and a second measuring axis for the 3D position detection lie mirror-symmetrically with respect to the X-Y plane.

**4.** Assembly according to Claim 3, **characterized in that** the projections of the first and second sensitivity vectors (v1, v2) that are mirror-symmetrical in relation to the X-Y plane onto the X-Y plane produce two identical vectors that are rotated by 45, 135, 225 or 315 degrees with respect to the X direction in the X-Y plane.

**5.** Assembly according to Claim 3 or 4, **characterized in that** a third sensitivity vector (v3) of a third measuring axis lies in the X-Y plane and is lineally independent of the two sensitivity vectors (v1, v2) that are mirror-symmetrical in relation to the X-Y plane.

**6.** Assembly according to Claim 5, **characterized in that** the third sensitivity vector (v3) is perpendicular to the sensitivity vectors (v1, v2) that are mirror-symmetrical in relation to the X-Y plane.

**7.** Assembly according to Claim 3 or 4, **characterized in that** a third and a fourth measuring axis are provided for 3D position detection, having a third and a fourth sensitivity vector (v3, v4), which is respectively obtained by a rotation by 90 degrees about the Z direction of the first or the second sensitivity vector (v1, v2) of the first measuring axis and the second measuring axis.

**8.** Assembly according to Claim 7, **characterized in that** the first and second measuring axes are integrated in a first scanning head (1) and the third and fourth measuring axes are integrated in a second scanning head (1').

**9.** Assembly according to one of Claims 1-7, **characterized in that** all of the measuring axes for the 3D position detection are integrated in a single scanning head (1).

**10.** Assembly according to one of the preceding claims, **characterized in that** measuring axes for the 3D position detection are provided in at least three corners of the table (2).

**Revendications**

**1.** Système de positionnement d'une pièce à usiner par rapport à un outil, comportant :

- une table mobile (2) destinée à recevoir une pièce à usiner (4), dans lequel la table (2) exécute des mouvements dans deux directions de mouvement principales (X, Y) pendant le traitement de la pièce à usiner,
- un ou plusieurs étalons de mesure (5) plans qui sont disposés de façon stationnaire autour de l'outil (3) et s'étendent dans le plan des directions de mouvement principales (X, Y),
- des têtes de balayage (1, 1') destinées à détecter la position de la table (2) par rapport aux étalons de mesure (5), lesquelles têtes de balayage sont montées sur au moins trois angles de la table (2), dans lequel la position de la table (2) peut être déterminée par les têtes de balayage (1, 1') selon six degrés de liberté (X, Y, Z, rX, rY, rZ),
- dans lequel, à au moins l'un des angles, une ou plusieurs têtes de balayage (1, 1') sont présentes avec au total au moins trois axes de mesure pour détecter la position 3D dans trois directions spatiales (X, Y, Z) indépendantes,

**caractérisé en ce que**

- des vecteurs de sensibilité (v1, v2, v3, v4) des axes de mesure pour la détection de position 3D ne sont ni parallèles au plan X-Z, ni parallèles au plan Y-Z.

2. Système selon la revendication 1, **caractérisé en ce que** les vecteurs de sensibilité (v1, v2, v3, v4) des axes de mesure, pour la détection de position 3D, délimitent au moins un angle de 1° avec le plan X-Z par rapport au plan Y-Z.

3. Système selon la revendication 1 ou 2, **caractérisé en ce que** des premier et deuxième vecteurs de sensibilité (v1, v2) d'un premier et d'un deuxième axe de mesure pour détecter la position 3D sont disposés de manière symétrique dans un miroir par rapport au plan X-Y.

4. Système selon la revendication 3, **caractérisé en ce que** les projections des premier et deuxième vecteurs de sensibilité (v1, v2) symétriques dans un miroir par rapport au plan X, Y, produisent sur le plan X, Y deux vecteurs identiques qui sont soumis à une rotation de 45, 135, 225 ou 315 degrés par rapport à la direction X dans le plan X-Y.

5. Système selon la revendication 3 ou 4, **caractérisé en ce qu'**un troisième vecteur de sensibilité (v3) d'un troisième axe de mesure se situe dans le plan X-Y et est linéairement indépendant des deux vecteurs de sensibilité (v1, v2) symétriques dans un miroir par rapport au plan X-Y.

6. Système selon la revendication 5, **caractérisé en ce que** le troisième vecteur de sensibilité (v3) est perpendiculaire aux vecteurs de sensibilité (v1, v2) symétriques dans un miroir par rapport au plan X-Y.

7. Système selon la revendication 3 ou 4, **caractérisé en ce que**, pour détecter la position 3D, il est prévu des troisième et quatrième axes de mesure ayant des troisième et quatrième vecteurs de sensibilité (v3, v4), qui sont respectivement obtenus par une rotation de 90 degrés autour de la direction Z des premier ou deuxième vecteurs de sensibilité (v1, v2) des premier et deuxième axes de mesure.

8. Système selon la revendication 7, **caractérisé en ce que** les premier et deuxième axes de mesure sont intégrés à une première tête de balayage (1) et les troisième et quatrième axes de mesure sont intégrés à une deuxième tête de balayage (1').

9. Système selon l'une quelconque des revendications 1-7, **caractérisé en ce que** tous les axes de mesure sont intégrés à une même tête de balayage (1) pour la détection de position 3D.

10. Système selon l'une quelconque des revendications précédentes, **caractérisé en ce que** des axes de mesure sont présents pour la détection de position 3D sur au moins trois angles de la table (2).

Fig. 1

Fig. 2

Fig. 3

Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7483120 B2
- EP 1762828 A2

- DE 102013220184